(19) Europäisches Patentamt
European Patent Office
Office européen des brevets

(11) **EP 2 117 018 A1**

(12) **EUROPEAN PATENT APPLICATION**
published in accordance with Art. 153(4) EPC

(43) Date of publication:
**11.11.2009 Bulletin 2009/46**

(51) Int Cl.:
*H01F 1/26* (2006.01)   *H01F 1/147* (2006.01)
*H01F 1/24* (2006.01)   *H01F 1/37* (2006.01)
*H01F 41/02* (2006.01)   *H05K 1/02* (2006.01)
*H05K 1/03* (2006.01)   *H05K 9/00* (2006.01)

(21) Application number: **08703665.3**

(22) Date of filing: **22.01.2008**

(86) International application number:
**PCT/JP2008/050821**

(87) International publication number:
**WO 2008/090891 (31.07.2008 Gazette 2008/31)**

(84) Designated Contracting States:
**AT BE BG CH CY CZ DE DK EE ES FI FR GB GR
HR HU IE IS IT LI LT LU LV MC MT NL NO PL PT
RO SE SI SK TR**

(30) Priority: **23.01.2007   JP 2007012092
13.04.2007   JP 2007105496
12.06.2007   JP 2007154751**

(71) Applicants:
• **National University Corporation
Tohoku University
Sendai-shi
Miyagi 980-8577 (JP)**
• **Sumitomo Osaka Cement Co., Ltd.
Tokyo 102-8465 (JP)**

(72) Inventors:
• **OHMI, Tadahiro
Sendai-shi
Miyagi 980-8577 (JP)**
• **TERAMOTO, Akinobu
Sendai-shi
Miyagi 980-8577 (JP)**
• **ISHIZUKA, Masayuki
Tokyo 102-8465 (JP)**
• **HIDAKA, Nobuhiro
Tokyo 102-8465 (JP)**
• **SHIRAKATA, Yasushi
Tokyo 114-8515 (JP)**

(74) Representative: **Glawe, Delfs, Moll
Patent- und Rechtsanwälte
Postfach 26 01 62
80058 München (DE)**

(54) **COMPOSITE MAGNETIC BODY, ITS MANUFACTURING METHOD, CIRCUIT SUBSTRATE USING THE SAME, AND ELECTRONIC DEVICE USING THE SAME**

(57)   There are provided a composite magnetic body exhibiting a sufficiently low magnetic loss at frequencies of several hundreds of megahertz to several gigahertz, and a method of manufacturing the same. The composite magnetic body contains a magnetic powder dispersed in an insulating material. The magnetic powder is in a spherical shape or an elliptic shape. The composite magnetic body has any one of the following characteristics (a) to (c):

(a) the relative magnetic permeability $\mu r$ is larger than 1 and the loss tangent tan $\delta$ is 0.1 or less, at a frequency of 1 GHz or 500 MHz;

(b) the real part $\mu r'$ of the complex permeability is more than 10 and the loss tangent tan $\delta$ is 0.3 or less, at a frequency of 1.2 GHz or less; and

(c) the real part $\mu r'$ of the complex permeability is more than 1 at a frequency of 4 GHz or less, and the loss tangent tan $\delta$ is 0.1 or less at a frequency of 1 GHz or less.

FIG. 1

## Description

Technical Field

The present invention relates to high-frequency circuit boards and high-frequency electronic components, and particularly to a composite magnetic body suitable for the high-frequency circuit boards and high-frequency electronic components and a method of manufacturing the composite magnetic body.

Background Art

As the speed and the packing density of an information communication apparatus are increased, it is strongly desired that electronic components and circuit boards contained in an electronic apparatus become smaller, and that their power consumptions are reduced. The wavelength $\lambda g$ of electromagnetic waves propagating in a material is generally expressed by the following Equation 1, using the wavelength $\lambda 0$ of electromagnetic waves propagating in a vacuum, and the relative permittivity $\varepsilon r$ and relative magnetic permeability $\mu r$ of the material. It is thus known that as the relative permittivity $\varepsilon r$ and the relative magnetic permeability $\mu r$ are increased, the electronic component and circuit board can be miniaturized because the wavelength shortening is increased.

[Equation 1]

$$\lambda g = \lambda 0/(\varepsilon r \cdot \mu r)^{1/2}$$

The characteristic impedance $Zg$ of a material can be expressed by the following Equation 2 using the vacuum characteristic impedance $Z0$. For example, an approach has been reported for reducing the power consumption of an electronic component or a circuit board by increasing the relative magnetic permeability $\mu r$ to increase the characteristic impedance $Zg$ and the terminating resistance, thus reducing the current running through wires.

[Equation 2]

$$Zg = Z0 \cdot (\mu r/\varepsilon r)^{1/2}$$

However, an eddy current is generated at the surface of a magnetic material at high frequencies that information communication apparatuses or the like use. The eddy current is produced in a direction in which the applied magnetic field is canceled, and consequently reduces the apparent magnetic permeability of the material. Also, the increase in eddy current causes energy loss due to Joule's heat. It is therefore difficult to use magnetic materials for circuit boards and electronic components. In order to reduce the eddy current, it is more effective to reduce the diameter of magnetic powder than to reduce the skin depth d expressed by the following Equation 3.

[Equation 3]

$$d = 1/(n \cdot f \cdot \mu 0 \cdot \mu r \cdot \sigma)^{1/2}$$

In the equation, f represents the signal frequency, $\sigma$ represents the electric conductivity of magnetic powder, and $\mu 0$ represents the space permeability.

As the nanotechnology progresses, magnetic particles become finer, and some cases have been reported in which the decrease in relative magnetic permeability $\mu r$ of a material was prevented at a high frequency.

Patent Document 1 discloses that an electromagnetic wave absorber exhibiting superior radio wave absorption can be produced by dispersing an elliptic nanocrystalline magnetic powder in a resin to increase the imaginary part $\mu "$ of magnetic permeability, which is the magnetic loss term of the magnetic permeability expressed on a complex permeability basis.

Patent Document 2 provides a composite magnetic body exhibiting a low loss at about 300 MHz or less by dispersing magnetic particles having a plurality of particle sizes in a resin by dispersive mixing using screw stirring and ultrasonic agitation.

In Japanese Patent Application No. 2007-12092, the inventors of the present invention provide a composite magnetic body exhibiting a relative magnetic permeability $\mu r$ of more than 1 and a loss tangent $\tan \delta$ of 0.1 or less at frequencies of 500 MHz to 1 GHZ by appropriately dispersing spherical magnetic powder or elliptic magnetic powder in a resin by a rotation/revolution mixing using a dispersive medium.

Patent Document 1: JP-A-H11-354973
Patent Document 2: JP-A-2006-269134

Disclosure of Invention

Problems to be Solved by the Invention

Patent Document 1 discloses that an electromagnetic wave absorber exhibiting superior radio absorption over a wide range of frequencies can be produced by compounding an elliptic nanocrystalline magnetic powder with a resin. However, Patent Document 1 does not describe the process for dispersing magnetic particles in detail. Also, in order to interrupt or absorb electromagnetic waves, Patent Document 1 proposes a material having a large imaginary part $\mu''$ of magnetic permeability, which is the magnetic loss term, at working frequencies.

Unfortunately, materials exhibiting high magnetic losses cannot be used in applications requiring low magnetic loss, such as for circuit boards or electronic components.

On the other hand, Patent Document 2 discloses a composite magnetic body exhibiting low power consumption, capable of reducing the crosstalk and radiation noise, and therefore suitable for circuit boards and electronic components. In use of the spherical magnetic powder disclosed as in Patent Document 2, however, the demagnetizing factor of each particle is increased, and accordingly the relative magnetic permeability $\mu r$ is reduced. In this instance, in order to increase the relative magnetic permeability $\mu r$, the mixture concentration must be increased. However, a high mixture concentration tends to result in difficulty in manufacture, and, for example, makes it difficult to obtain uniform dispersion.

Furthermore, fine magnetic particles exhibit magnetic interaction in addition to electric double layer interaction and Van Der Waals attraction energy. Accordingly, such magnetic particles easily come together to form an aggregate. The aggregate of fine magnetic particles in a composite magnetic body acts as a large magnetic particle, and easily generate an eddy current at high frequencies to reduce the magnetic characteristics. Accordingly, screw stirring, ultrasonic agitation or the like is performed to prevent the magnetic particles from forming an aggregate in the manufacture of the composite magnetic body.

However, it has been found that the mixing method disclosed in Patent Document 2 does not uniformly disperse the magnetic particles in an insulating material because the energy externally applied to the aggregate is lower than the energy forming the aggregate, and consequently that the magnetic loss cannot be sufficiently reduced at frequencies in the range of several hundreds of megahertz to several gigahertz. Hence, it has been found that the mixing method disclosed in Patent Document 2 cannot sufficiently pulverize the aggregate.

In addition, since the magnetic powder contains magnetic particles having a plurality of particle sizes, it is necessary not only to select the type of magnetic powder, but also to select the particle size of the magnetic powder. This disadvantageously complicates the manufacturing process.

If the magnetic powder is a metal magnetic powder, the saturation magnetization and the magnetic permeability are high, but the electric resistivity is low ($10^{-6}$ to $10^{-4}$ $\Omega$cm). Accordingly, the metal magnetic powder increases the eddy current loss to degrade the magnetic characteristics in a high frequency region, as described above. The magnetic powder requires dispersing uniformly in a composite magnetic body. The use of an iron-based metal magnetic powder allows safer, more efficient and lower cost manufacture on an industrial scale than the use of nickel- or cobalt-based metal magnetic powder. If a metal oxide magnetic powder is used, on the other hand, the electric resistivity is higher (1 to $10^8$ $\Omega$cm) than that of the metal magnetic material. Accordingly, the eddy current loss is reduced at high frequencies, and the magnetic characteristics are not degraded much. However, the magnetic powder must be added to the composite magnetic body at a high concentration because the saturation flux density is 1/3 to 1/2 times that of metal magnetic materials.

The inventors found in Japanese Patent Application No. 2007-12092 that by appropriately dispersing a magnetic powder, the loss can be reduced even at frequencies in the range of 500 MHz to 1 GHz. However, 78-Permalloy (78Ni-22Fe alloy) constituting the composite magnetic body cannot sufficiently avoid the influence of the diamagnetic field because of its low plastic deformation ability, and it is difficult to allow the high-frequency magnetic field to coincide with the axis of easy magnetization because of its low degree of crystal orientation. This hinders further increase of magnetic permeability.

Accordingly, it is a first object of the present invention to provide a composite magnetic body produced by dispersing a magnetic powder in an insulating material, wherein the magnetic powder has a spherical or elliptic shape, and the composite magnetic body has a relative magnetic permeability $\mu r$ of more than 1 and a loss tangent tan $\delta$ of 0.1 or less at a frequency of I GHz.

It is a second object of the present invention to provide a composite magnetic body containing a magnetic powder easily plastic-deformed in the direction of a specific crystal orientation (herein the direction of axis of easy magnetization) by adding a metal element to alloy particles and applying a mechanical stress to the alloy particles, and an insulating material, wherein the longer axis direction of the elliptic magnetic powder coincides with the direction of axis of easy magnetization of the elliptic magnetic powder, and the composition magnetic material has a relative magnetic permeability $\mu r$ of more than 10 and a loss tangent tan $\delta$ of 0.3 or less at frequencies of 1.2 GHz or less.

It is a third object of the present invention is to provide a composite magnetic body that can exhibit a sufficiently low magnetic loss at frequencies in the range of several hundreds of megahertz to several gigahertz by use of either a metal magnetic powder or a metal oxide magnetic powder.

It is a fourth object of the present invention is to provide a method of producing any one of the above composite magnetic bodies.

It is a fifth object of the present invention is to provide a circuit board, an electronic component and an electronic apparatus including any one of the above composite magnetic bodies.

Means for Solving the Problems

As a result of intensive research, the present inventors have found that the loss can be reduced even at frequencies in the range of several hundreds of megahertz to several gigahertz by appropriately dispersing a magnetic powder, and that the magnetic permeability can further be increased at frequencies of 1.2 GHz or less by appropriately dispersing an elliptic magnetic powder and aligning the orientation of the elliptic magnetic powder.

That is, acording to a first aspect of the present invention, there is provided a composite magnetic body which includes a magnetic powder dispersed in an insulating material. The magnetic powder is in a spherical shape or an elliptic shape. In the composite magnetic body, the composite magnetic body has any one of the following characteristics (a) to (c):

(a) the relative magnetic permeability $\mu r$ is larger than 1 and the loss tangent tan $\delta$ is 0.1 or less, at a frequency of 1 GHz or 500 MHz;
(b) the real part $\mu r'$ of the complex permeability is more than 10 and the loss tangent tan $\delta$ is 0.3 or less, at a frequency of 1.2 GHz or less; and
(c) the real part $\mu r'$ of the complex permeability is more than 1 at a frequency of 4 GHz or less, and the loss tangent tan $\delta$ is 0.1 or less at a frequency of 1 GHz or less.

In the above-mentioned aspect of the present invention, It is preferable that the real part $\varepsilon r'$ of the complex permittivity of the composite magnetic body is 10 or more at a frequency of 1 GHz or less or that the real part $\varepsilon r'$ of the complex permittivity of the composite magnetic body is 10 or less at a frequency of 1 GHz or less.

In addition, according to a second aspect of the present invention, there is provided a method of manufacturing a composite magnetic body which includes the steps of preparing a slurry by dispersing an insulating material and a spherical or elliptic magnetic powder in a solvent to mix and of applying the slurry, followed by drying and firing. In the method, the step of preparing the slurry includes the steps of preparing a dispersion solvent by adding a surfactant in a solvent and of mixing the magnetic powder to the dispersion solvent. The step of mixing the magnetic powder includes the steps of adding a dispersive medium and performing rotation/revolution mixing.

In the above-mentioned aspect of the present invention, it is preferable that the rotation/revolution mixing is performed at a rotation speed of 100 rpm or more and a revolution speed of 100 rpm or more. It is more preferable that the rotation/revolution mixing is performed at a rotation speed of 500 rpm or more and a revolution speed of 200 rpm or more.

According to a third aspect of the present invention, there is provided a circuit board which includes the composite magnetic body as described above and an electronic apparatus which includes the circuit board.

According to a fourth aspect of the present invention, there is provided an electronic component which includes the composite magnetic body as described above.

According to a fifth aspect of the presnt invention, there is provided an electronic apparatus which includes the electronic component as described above.

According to a sixth aspect of the present invention, there is provided a circuit board which includes a composite magnetic body manufactured by the method as described above.

According to a seventh aspect of the present invention, there is provided an electronic apparatus which includes the circuit board as described above.

According to an eighth aspect of the present invention, there is provided an electronic component which includes a composite magnetic body manufactured by the method as described above.

According to a ninth aspect of the present invention, there is provided an electronic apparatus which includes the electronic component as described above.

Advantages

According to the present invention, by appropriately dispersing spherical or elliptic magnetic powder in a insulating material, a composite magnetic body having a relative magnetic permeability $\mu r$ of higher than 1 and a loss tangent tan $\delta$ of 0.1 or less at a frequency of 1 GHz. By using the composite magnetic body according to the present invention as the material of a circuit board and/or an electronic component, a miniaturized low-power consumption information communication apparatus used at frequencies in the range of several hundreds of megahertz to several gigahertz can be achieved, which is not easily achieved by use of a circuit board or electronic component made of only a dielectric material.

The present invention can also provide a composite magnetic body containing an insulating material and a magnetic powder containing a metal element that can be easily plastic-deformed in the direction of a specific crystal orientation (for example, the direction of axis of easy magnetization) by applying a mechanical stress, and an electronic apparatus using the same. The longitudinal direction of the elliptic magnetic powder coincides with the axis of easy magnetization of the elliptic magnetic powder, and the composition magnetic material has a relative magnetic permeability $\mu r$ of more than 10 and a loss tangent tan $\delta$ of 0.3 or less at frequencies of 1.2 GHz or less. By using the composite magnetic body having a high magnetic permeability according to the present invention as the material of a circuit board and/or an electronic component, a miniaturized low-power consumption information communication apparatus used at frequencies in the range of several hundreds of megahertz to 1 GHz can be achieved.

According to the present invention, by appropriately dispersing a magnetic power containing an iron-based magnetic powder or metal oxide magnetic powder in an insulating material by mixing, a composite magnetic body can be achieved which has a relative magnetic permeability $\mu r$ of higher than 1 at frequencies of 4 GHz or less, and a loss tangent $\tan \delta$ of 0.1 or less at frequencies of 1 GHz or less. By using the composite magnetic body according to the present invention as the material of a circuit board and/or an electronic component, a miniaturized low-power consumption information communication apparatus used at frequencies in the range of several hundreds of megahertz to several gigahertz can be achieved, which is not easily achieved by use of a circuit board or electronic component made of only a dielectric material.

Brief Description of Drawings

Fig. 1 is a graph showing the magnetic characteristics of a composite magnetic body prepared in Example 1 of the present invention plotted versus frequency.
Fig. 2 is a scanning electron microphotograph of the composite magnetic body prepared in Example 1 of the present invention.
Fig. 3 is a graph showing the magnetic characteristics of a composite magnetic body prepared in Example 2 of the present invention plotted versus frequency.
Fig. 4 is a scanning electron microphotograph of the composite magnetic body prepared in Example 2 of the present invention.
Fig. 5 is a graph showing the magnetic characteristics of a composite magnetic body prepared in a known method plotted versus frequency.
Fig. 6 is a scanning electron microphotograph of the composite magnetic body prepared in the known method.
Fig. 7 is a schematic view of the structure of a high-frequency circuit board according to Example 3 of the present invention.
Fig. 8 is a graph showing the transmission characteristic and the reflection characteristic of the high-frequency circuit board shown in Fig. 7 plotted versus frequency.
Fig. 9 is a schematic view of the structure of an antenna according to Example 4 of the present invention.
Fig. 10 is a graph showing the input reflection characteristic of the antenna shown in Fig. 9 plotted versus frequency.
Fig. 11 is a graph showing the magnetic characteristics of a composite magnetic body prepared in Example 5 of the present invention plotted versus frequency.

Fig. 12 is a scanning electron microphotograph of the composite magnetic body prepared in Example 5 of the present invention.
Fig. 13 is a graph showing the result of X-ray diffraction of the composite magnetic body prepared in Example 5 of the present invention.
Fig. 14 is a graph showing the magnetic characteristics of a composite magnetic body prepared in a known method plotted versus frequency.
Fig. 15 is a scanning electron microphotograph of the composite magnetic body prepared in the known method.
Fig. 16 is the result of X-ray diffraction of the composite magnetic body prepared in a known method.
Fig. 17 is a schematic view of the structure of an antenna prepared in Example 6 of the present invention.
Fig. 18 is a graph showing the input reflection characteristic of an antenna plotted versus frequency.
Fig. 19 is a graph showing the magnetic characteristic of a composite magnetic body prepared in Example 7 of the present invention plotted versus frequency.
Fig. 20 is a scanning electron microphotograph of the composite magnetic body prepared in Example 7 of the present invention.
Fig. 21 is a graph showing the magnetic characteristic of a composite magnetic body prepared in Example 8 of the present invention plotted versus frequency.
Fig. 22 is a scanning electron microphotograph of a composite magnetic body prepared in Example 8 of the present invention.

Reference Numerals

10    composite magnetic substrate
12    conductor line
14    feed port
16    composite magnetic antenna
20    composite magnetic body
22    strip conductor
24    conductor plate
26    feeding point

Best Modes for Carrying Out the Invention

A magnetic powder constituting a composite magnetic body according to an embodiment of the present invention will first be described.
The material of the magnetic powder may be at least one metal selected from the group consisting of iron (Fe), cobalt (Co) and nickel (Ni), or an alloy or compound of the metal. Preferably, the material of the magnetic powder is selected from iron or iron-based alloy prepared by adding at least one metal element selected from the group including titanium (Ti), aluminum (Al), chromium (Cr), manganese (Mn), cobalt (Co), copper (Cu), zinc (Zn), niobium (Nb), molybdenum (Mo), vanadium (V), indium (In) and tin (Sn) into iron or iron-based alloy having a high saturation magnetization, such as iron (Fe), Permalloy (Fe-Ni alloy), Supermalloy (Fe-Ni-Mo alloy), Sendust (Fe-Si-At alloy), Fe-Si alloy, Fe-Co-based alloy, Fe-Cr alloy, Fe-Cr-Si alloy, iron (Fe)-nitrogen (N)-based alloy, iron (Fe)-carbon (C)-based alloy, iron (Fe)-boron (B)-based alloy, iron (Fe)-phosphorus (P)-based alloy, iron (Fe)-aluminum (Al), or the like. The magnetic powder prepared by adding such a metal element to iron or an iron-based alloy becomes soft and its plastic deformation ability is enhanced. Accordingly, the magnetic powder is easily plastic-deformed by applying a mechanical stress, and an elliptic magnetic powder having a high aspect ratio can readily be produced. In addition, since the longitudinal direction of the elliptic magnetic powder coincides with the axis of easy magnetization, the magnetic permeability of the composite magnetic body can be enhanced.

Preferably, the metal element content is in the range of 0.1 % to 90% by weight. This is because less than 0.1% by weight of the metal element does not allow sufficient plastic deformation of the soft magnetic powder, and because more than 90% by weight of the metal element results in a reduced saturation magnetization of the magnetic powder due to a small magnetic moment of the metal element.

Ferrite compounds having high electric resistivities are also preferred, such as magnetite ($Fe_3O_4$), manganese (Mn)-zinc (Zn) ferrite, nickel (Ni)-zinc (Zn) ferrite, cobalt (Co) ferrite, manganese (Mn) ferrite, nickel (Ni) ferrite, copper (Cu) ferrite, zinc (Zn) ferrite, magnesium (Mg)ferrite, lithium (Li) ferrite, manganese (Mn)-magnesium (Mg) ferrite, copper (Cu)-zinc (Zn) ferrite, and manganese (Mn)-zinc (Zn) ferrite.

Preferably, the magnetic powder content in the composite magnetic body is in the range of 10% to 95% by volume, preferably 10% by volume or more, and particularly preferably in the range of 10% to 90% by volume. Ten percent by volume of magnetic powder is too small to obtain a high relative magnetic permeability $\mu$r. In contrast, as the magnetic powder content is increased, it becomes difficult to coat the composite magnetic body. In particular, more than 95% by volume of magnetic powder accounts for such a high proportion in the composite magnetic body that a coating of the insulating material cannot be formed, and an aggregate is formed to increase the loss tangent tan $\delta$.

The magnetic powder containing the above-described material may be in a spherical·or elliptic shape, and preferably has a particle size in the range of 0.01 to 10 $\mu$m. The reason why the range of 0.01 to 10 $\mu$m is preferred is that the particle size of the magnetic powder has a close connection with the saturation magnetization. If the particle size is reduced, some changes occur, such as increase in number of particles, decrease in volume per particle, and increase in total area. The increase in total area more than in volume means that the property in which the surface is involved is dominated by the particles. In general, the surface layer has a different composition and structure from the interior. If the particle size is reduced, atoms involved in the magnetic characteristics are relatively reduced to reduce the saturation magnetization. Accordingly, a particle size of at least 0.01 $\mu$m or more is required. Also, since excessively large particles cause an eddy current at high frequencies, the upper limit of the average particle size is 10 $\mu$m.

The elliptic magnetic powder is formed by mechanically deforming the spherical magnetic powder by the shearing stress of the dispersive medium during mixing the magnetic powder in a dispersion solvent, and preferably has thickness of 0.1 to 1 $\mu$m. It is difficult to form an elliptic magnetic powder having a thickness of less than 0.1 $\mu$m, and such an elliptic magnetic powder is difficult to handle. In contrast, an elliptic magnetic powder having a thickness of more than 1 $\mu$m undesirably causes an eddy current to degrade the magnetic characteristics at high frequencies. In addition, if the elliptic magnetic powder has an aspect ratio (length/thickness) of less than 2, the demagnetizing factor of the powder is undesirably increased to reduce the relative magnetic permeability of the composite magnetic body.

The insulating material contained in the composite magnetic body will now be described.

If the composite magnetic body is used for a circuit board, the permittivity is preferably low from the viewpoint of increasing the characteristic impedance. Accordingly, the insulating material is preferably selected from synthetic resins having low permittivities, such as polyimide resin, polybenzoxazole resin, polyphenylene resin, polybenzocyclobutene resin, polyarylene ether resin, polysiloxane resin, epoxy resin, polyester resin, fluorocarbon polymer, polyolefin resin, polycycloolefin resin, cyanate resin, polyphenylene ether resin, and polystyrene resin.

If a high permittivity is required as in the use for a capacitor or an antenna element, a ceramic, such as $Al_2O_3$, $SiO_2$, $TiO_2$, $2Mg \cdot SiO_2$, $MgTiO_3$, $CaTiO_3$, $SrTiO_3$ or $BaTiO_3$, or a mixture of these inorganic materials and an organic material may be used as required.

Now, description will be made as regards a method of manufacturing the composite magnetic body according to an embodiment of the present invention.

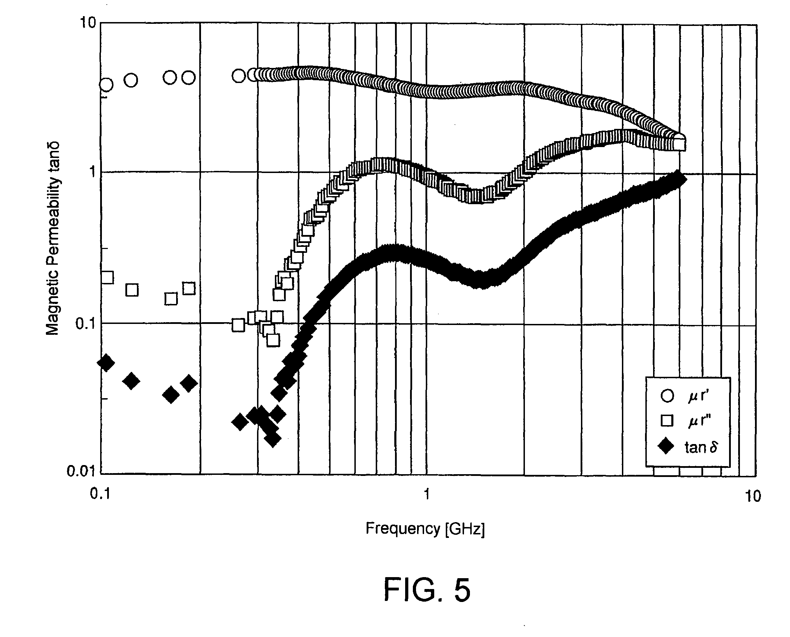

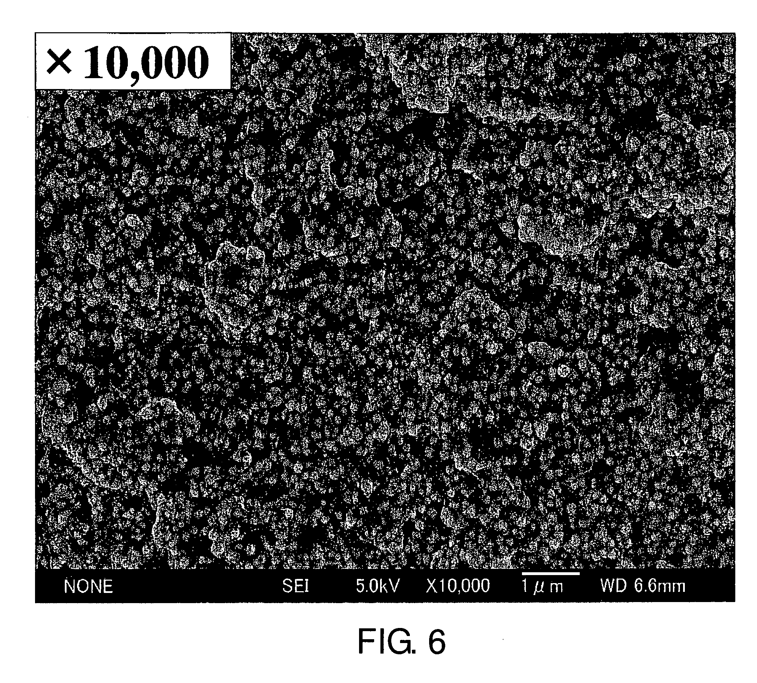

For comparative evaluation, first, the known method disclosed in Patent Document 2 by the present inventors was examined. One gram of 78-Permalloy magnetic powder (Ni:78%-Fe:22% alloy) having an average particle size of 0.15 $\mu$m and a dispersion liquid prepared by dissolving a nitrogen-containing graft polymer as a surfactant in 10 g of 4:1 xylene-cyclopentanone mixed solution were mixed by rotation/revolution stirring and ultrasonic irradiation agitation, thus preparing a slurry. The slurry and 0.5 g of resin varnish prepared by diluting a polycycloolefin resin to a solid content of 40% were mixed by rotation/revolution stirring and ultrasonic irradiation agitation. The resulting paste was subjected to concentration, application, drying, heat treatment and press forming to complete a composite magnetic body. The complex permeability of the resulting composite magnetic body was measured by a parallel line method, and resulted in a relative magnetic permeability $\mu$r of 4 and a magnetic loss tan $\delta$ of 0.3 at a frequency of 1 GHz. It was found that while superior magnetic characteristics were exhibited up to a frequency of about 200 to 300 MHz, the magnetic loss was increased at frequencies of 300 MHz or more (see Fig. 5). The dispersibility of the magnetic powder in a sheet of the composite magnetic body was observed through a scanning electron microscope. It was found that spherical particles had come together to form an aggregate of about 1 $\mu$m or more (see Fig. 6).

Accordingly, the present inventors have conducted intensive research, and have found that a composite magnetic body exhibiting a relative magnetic permeability $\mu$r of 1 or more and a loss tangent tan $\delta$ of 0.1 or less at frequencies of 1 GHz or less can be produced by mixing in the following manufacturing method.

The greatest feature of the production method according to the present invention is that iron or iron-based alloy having a high saturation magnetization, or a ferrite compound having a high electric resistivity is mixed with an insulating material in a solvent in a mixing vessel containing a dispersive medium by rotation/revolution stirring at a high speed (a rotation speed of 100 rpm or more and a revolution speed of 100 rpm or more, preferably a rotation speed of 500 rpm or more and a revolution speed of 200 rpm or more). The dispersive medium produces a high shearing stress to deform the magnetic particles into an elliptic shape or pulverize the aggregate of the particles. Thus, the dispersibility of the magnetic powder is increased, and the magnetic powder can be present uniformly at a high concentration in the composite magnetic body.

More specifically, the manufacturing method according to the present invention includes the step of preparing a slurry by dispersing a magnetic powder or a magnetic powder containing a metal element in a solvent. This step includes the step of preparing a dispersion solvent by adding a surfactant in the solvent, and the mixing step of mixing the magnetic powder to the dispersion solvent. For mixing the magnetic powder to the dispersion solvent, a dispersive medium is added, and rotation/revolution mixing was performed with the dispersive medium contained. Thus, the magnetic powder plastic-deformed in the direction of a specific crystal plane orientation is deformed into an elliptic shape by a mechanical stress produced by the dispersive medium, and then an insulating material is added.

Thus, a slurry containing a solvent, a surfactant, a magnetic powder, a dispersive medium and an insulating material is prepared. After the rotation/revolution mixing, the dispersive medium is removed from the resulting mixture. The step of removing the dispersive medium may be performed before adding and mixing the insulating material. For removing the dispersive medium, the mixture may be allowed to stand until the dispersive medium is separated from the solvent and other constituent, or the mixture may be subjected to centrifugation to separate the dispersive medium from the mixture.

Apparatuses that can be used in the above mixing step of mixing the solvent, the surfactant, the magnetic powder, the dispersive medium and the insulating material include kneaders, roll mills, pin mills, sand mills, ball mills and planet ball mills. In use of the dispersive medium of the invention, sand mills, ball mills or planet ball mills are suitable.

Dispersive media include metals or metal oxides of aluminum, steel, lead or the like, sintered oxides such as alumina, zirconia, silicon dioxide and titania, sintered nitrides such as silicon nitride, sintered silicides such as silicon carbide, and glasses such as soda glass, lead glass and high-specific gravity glass. From the viewpoint of mixing efficiency, the dispersive medium is preferably zirconia, steel or stainless steel, having a specific gravity of 6 or more. The dispersive medium features a higher hardness than the magnetic powder.

Since the mixing is performed by impact produced by collision with the dispersive medium, the dispersibility is increased as the number of collisions is increased. As the average grain size of the dispersive medium is reduced, the number of grains packed in a unit volume is increased, and the number of collisions is increased to increase the dispersibility, accordingly. However, a medium having an excessively small grain size is difficult to separate from the slurry. Accordingly, a grain size of at least 0.1 mm or more is required. In contrast, a dispersive medium having an excessively large grain size results in reduced collisions and reduced dispersibility. Thus, the upper limit of the average grain size is 3.0 mm.

If the mixing and agitation time is too short, the spherical magnetic particles cannot be sufficiently deformed into an elliptic shape. If the mixing and agitation time is too long, the deformed elliptic magnetic particles are then pulverized. Consequently, an appropriate aspect ratio (length/thickness) cannot be maintained, and the magnetic characteristics are degraded at high frequencies. Accordingly, the mixing and agitation time is preferably about 30 minutes, and is appropriately controlled by adjusting the amounts of raw materials to be initially introduced and the rotation and revolution speeds for agitation.

The application method of the resulting slurry will now be described. The slurry may be formed into a sheet by any known forming technique, such as press, doctor blade method or injection molding, thus forming a dry film. From the viewpoint of forming a multilayer composite of the composite magnetic body, a doctor blade method is preferably selected among these methods to form a sheet. The slurry is concentrated by evaporating the solvent to adjust the viscosity so as to be suitable for the application method. After the application of the slurry, the elliptic magnetic powder is aligned in the direction parallel to the sheet by a magnetic field, if necessary, before drying. Then the elliptic particles are aligned in the direction parallel to the surface of the sheet. At this time, the axis of easy magnetization in the elliptic particles is oriented in the direction of the longer axis of the elliptic particles. Consequently, the shape anisotropy and the crystal anisotropy are simultaneously aligned.

Finally, the thus formed dry film is subjected to heat treatment and press forming in a reducing atmosphere or in a vacuum, and thus the composite magnetic body is completed.

The greatest feature of the present invention is that the elliptic magnetic powder constituting the composite magnetic body is easy to plastic-deform in the direction of a specific crystal orientation (in the direction of the axis of easy magnetization, here), is easily plastic-deformed by applying a mechanical stress, has a high aspect ratio, and is arranged (aligned) in a direction parallel to a specific direction by applying an external magnetization for manufacturing the composite magnetic body. Accordingly, the magnetic permeability of the composite magnetic body can be enhanced by reducing the demagnetizing factor in the direction of the surface of the composite magnetic body and by allowing the longitudinal direction of the elliptic magnetic powder to coincide with the direction of the axis of easy magnetization.

The manufacturing method of the present invention can reduce the local aggregation of magnetic particles in the composite magnetic body, and, thus, can achieve both the increase in relative magnetic permeability $\mu r$ and the decrease in magnetic loss $\tan \delta$, at high frequencies.

The present invention will now be described in detail with reference to Examples 1 to 8. However, the invention is not limited to these Examples.

Example 1

One gram of 78-Permalloy magnetic powder (Ni:78%-Fe:22% alloy) having an average particle size of 0.15 $\mu$m was mixed to a dispersion liquid prepared by dissolving a nitrogen-containing graft polymer as a surfactant in 10 g of 4:1 xylene-cyclopentanone mixed solution, and zirconia beads having an average grain size of 200 $\mu$m were further added as the dispersive medium to the mixture. The mixture in this state was subjected to planet stirring for 30 minutes to deform the magnetic powder into an elliptic shape. To the resulting slurry was added 0.5 g of resin varnish prepared by diluting a polycycloolefin resin to a solid content of 40%, and then the slurry was further mixed by planet stirring for 5 minutes. Zirconia beads were further added as the dispersive medium, and planet stirring was performed another five minutes. The planet stirring was performed at a rotation speed of 2000 rpm and a revolution speed of 800 rpm.

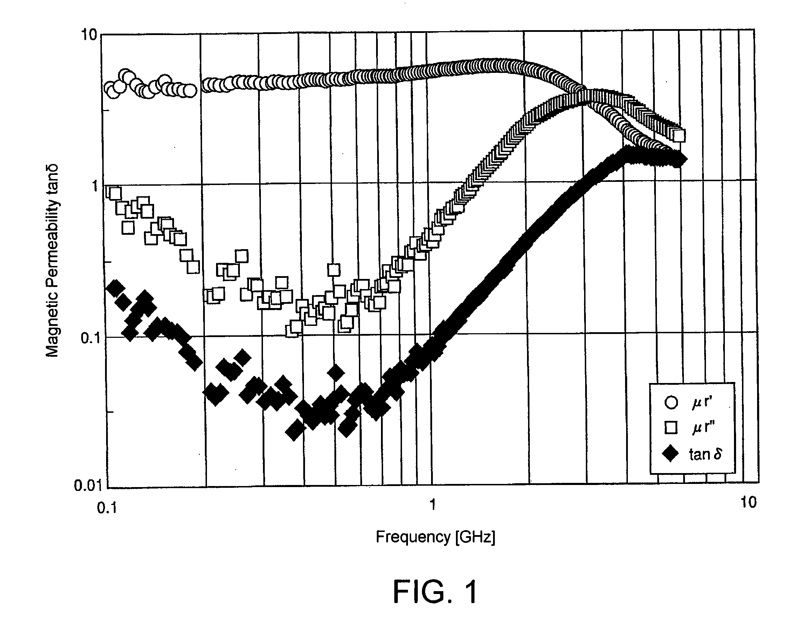

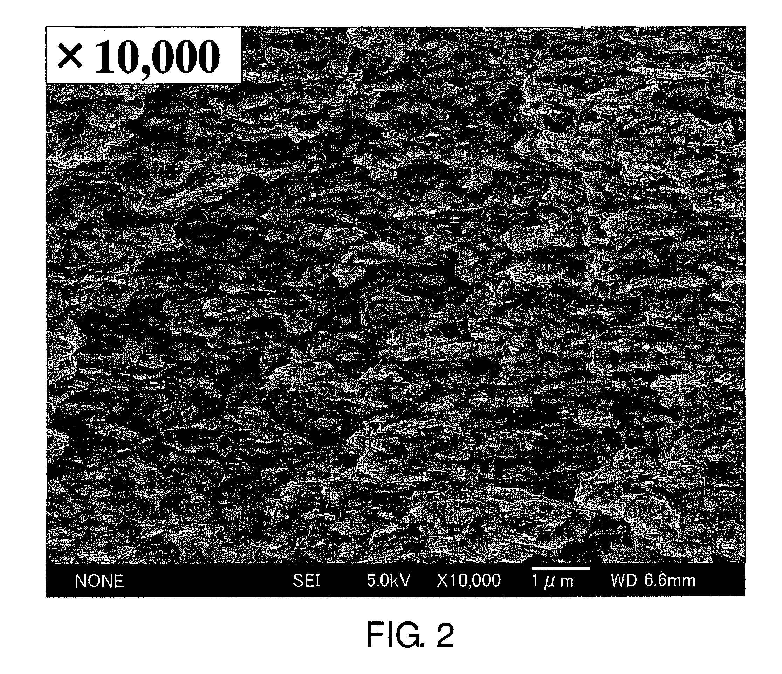

The resulting mixture was allowed to stand until the dispersive medium was sedimented (while the magnetic powder has a specific gravity of 7 to 8, zirconia has a specific gravity of 6 to 7. However, while the zirconia beads have a grain size of 200 $\mu$m, the magnetic powder has a particle size of 0.15$\mu$m. Since the zirconia beads are heavier than the magnetic powder, the zirconia beads can sediment). The supernatant was placed in a rotary evaporator, and the solvent was evaporated at 50°C under a reduced pressure of 2.7 kPa (the boiling point of the solvent is reduced by reducing the pressure) so that the viscosity was adjusted so as to be suitable for application by a doctor blade method. The resulting mixture was formed into a film by a doctor blade method, and the film was dried a room temperature while a magnetic field of 1.6 $\times$ 10$^5$ A/m was applied to the film to align the magnetic particles. The resulting dry film was subjected to pressing firing in a vacuum press apparatus. For pressing, the temperature was increased to 130°C over a period of 20 minutes under atmospheric pressure, and subsequently a pressure of 2 MPa was applied and held for 5 minutes. Then, the temperature was increased to 160°C and held for 40 minutes. Thus, the resin was cured to produce a composite magnetic body having an area of 30 mm square and a thickness of about 60 $\mu$m. The complex permeability of the composite magnetic body was measured by a parallel line method, and resulted in a relative magnetic permeability $\mu r$ of 6 and a magnetic loss $\tan \delta$ of 0.08 at 1 GHz (see Fig. 1). The structure of the composite magnetic body is shown in the microphotograph of Fig. 2. It is shown that the magnetic particles are in an elliptic shape and aligned in a direction in which a magnetic field is applied.

EXAMPLE 2

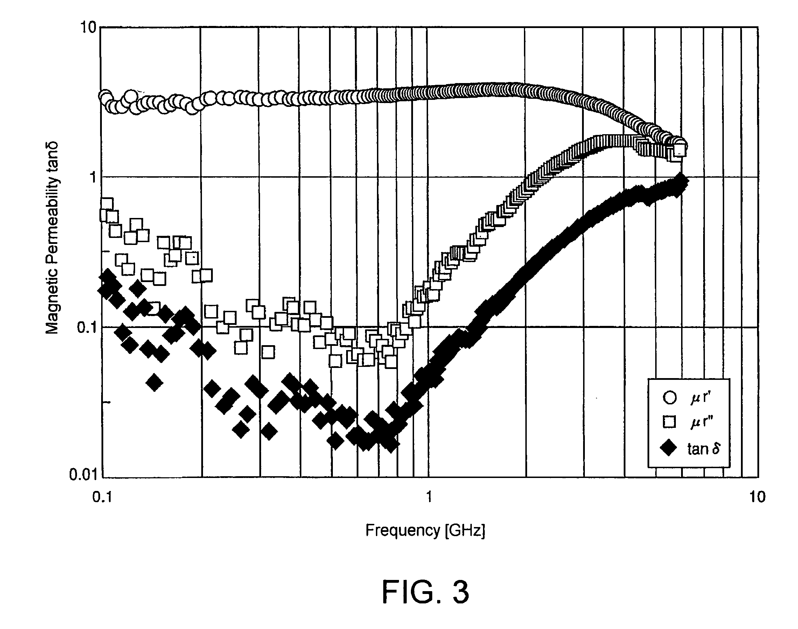

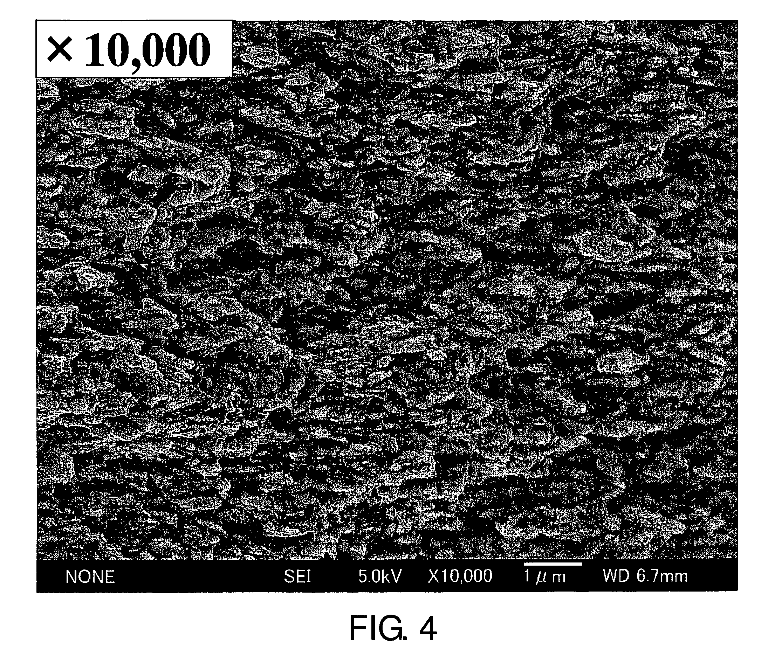

A composite magnetic body having an area of 30 mm square and a thickness of 60 $\mu$m was produced using 1 g of 45-Permalloy magnetic powder (Ni:45%-Fe: 55% alloy) having an average particle size of 0.15 $\mu$m under the same conditions as in Example 1. The complex permeability of the composite magnetic body was measured by a parallel line method, and resulted in a relative magnetic permeability $\mu r$ of 5 and a magnetic loss $\tan \delta$ of 0.05 at 1 GHz (see Fig. 3). The structure of the composite magnetic body is shown in the microphotograph of Fig. 4.

EXAMPLE 3

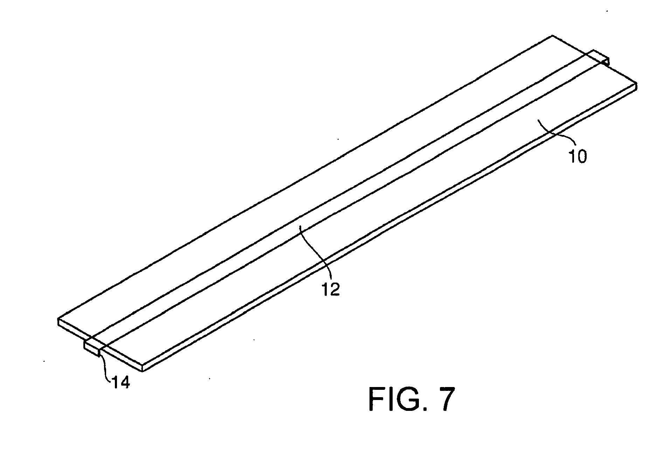

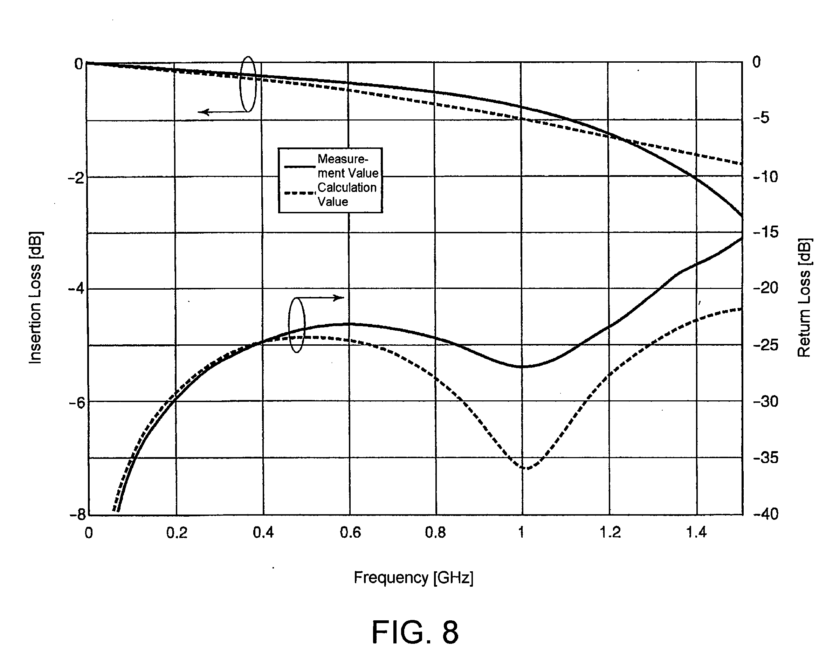

An example will be described in which the composite magnetic body was used for a circuit board. First, 6 composite magnetic dry films having a thickness of about 60 $\mu$m prepared by the process shown in Example 1 were stacked and subjected to pressing firing, thus forming a composite magnetic material having a thickness of about 350 $\mu$m. Furthermore, the composite magnetic material was sandwiched between low-permittivity resin films, and then heated to cure the resin. Then, the surface of the resin was plated with copper to form a wiring pattern (microstrip line) of 30 mm in length and 0.9 mm in width. The external view of the circuit board is shown in Fig. 7. Fig. 8 shows the transmission characteristic and the reflection characteristic of the circuit board. The measurement results favorably coincide with the calculation values obtained by an electromagnetic field simulator HFSS, and thus it is shown that a desired relative magnetic permeability and loss were obtained at high frequencies.

EXAMPLE 4

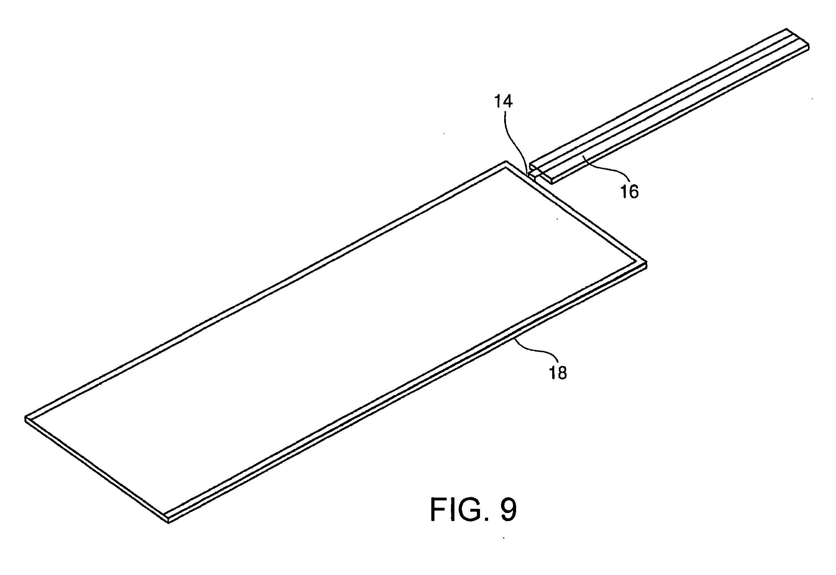

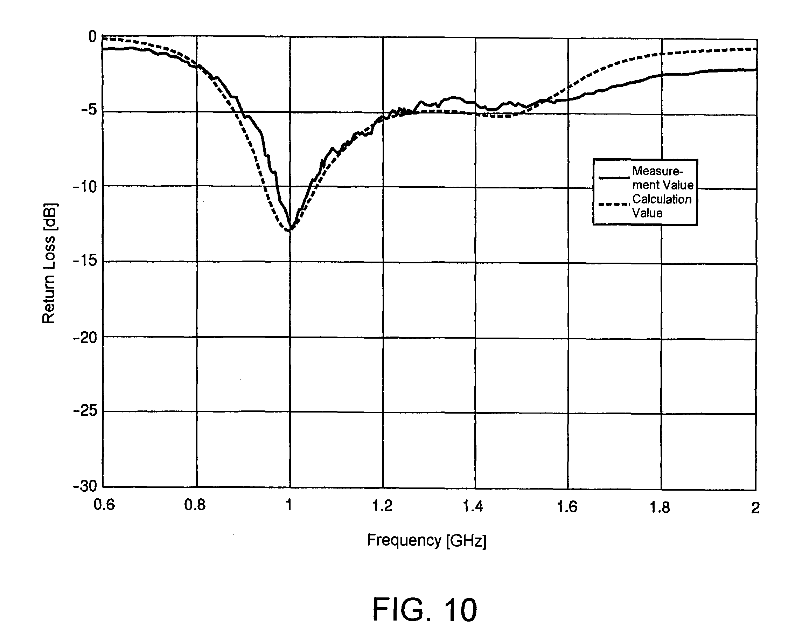

A case will now be described in which the composite magnetic body was used as a mobile device antenna, which is an example of electronic components. As shown in Fig. 9, an antenna element had a structure in which a conductor line having a length of 44 mm and a width of 1.5 mm was sandwiched between two composite magnetic materials of 42 mm in length, 5 mm in width and 0.35 mm in thickness. The antenna element was connected to a conductor plate of 80 mm in length, 35 mm in width and 1 mm in thickness, and 50 Ω was fed at a connection point. Fig. 10 shows the input reflection characteristic of the antenna. The measurement results favorably coincide with the calculation values obtained by an electromagnetic field simulator HFSS, and thus it is shown that a desired relative magnetic permeability and loss were obtained at high frequencies.

EXAMPLE 5

Two grams of Permalloy magnetic powder containing a metal element and having an average particle size of 0.25 μm was mixed to a dispersion liquid prepared by dissolving a nitrogen-containing graft polymer as a surfactant in 10 g of 4:1 xylene-cyclopentanone mixed solution, and zirconia beads having an average grain size of 200 μm were further added as the dispersive medium to the mixture. The mixture in this state was subjected to planet stirring for 50 minutes to deform the magnetic powder into an elliptic shape. To the resulting slurry was added 0.5 g of resin varnish prepared by diluting a polycycloolefin resin to a solid content of 40%, and then the slurry was further mixed by planet stirring for 5 minutes. The planet stirring was performed at a rotation speed of 2000 rpm and a revolution speed of 800 rpm.

The resulting mixture was allowed to stand until the dispersive medium was sedimented (while the magnetic powder has a specific gravity of 7 to 8, zirconia has a specific gravity of 6 to 7. However, while the zirconia beads have a grain size of 200 μm, the magnetic powder has a particle size of 0.25μm. Since the zirconia beads are heavier than the magnetic powder, the zirconia beads can sediment). The supernatant was placed in a rotary evaporator, and the solvent was evaporated at 50°C under a reduced pressure of 2.7 kPa (the boiling point of the solvent is reduced by reducing the pressure). After a film was formed by a doctor blade method, the film was dried at room temperature while a magnetic field of 1.6 × $10^5$ A/m was applied to the film to align the magnetic particles. Six resulting dry films were stacked and subjected to pressing firing in a vacuum press apparatus. For pressing, the temperature was increased to 130°C over a period of 20 minutes under atmospheric pressure, and subsequently a pressure of 2 MPa was applied and held for 5 minutes. Then, the temperature was increased to 160°C and held for 40 minutes. Thus, the resin was cured to produce a composite magnetic material having a thickness of 350 μm.

The particles of the magnetic powder in the resulting magnetic material were finally deformed an elliptic shape in the direction of axis of easy magnetization, and became in a state in which their crystal planes parallel to the axis of easy magnetization are piled in the thickness direction.

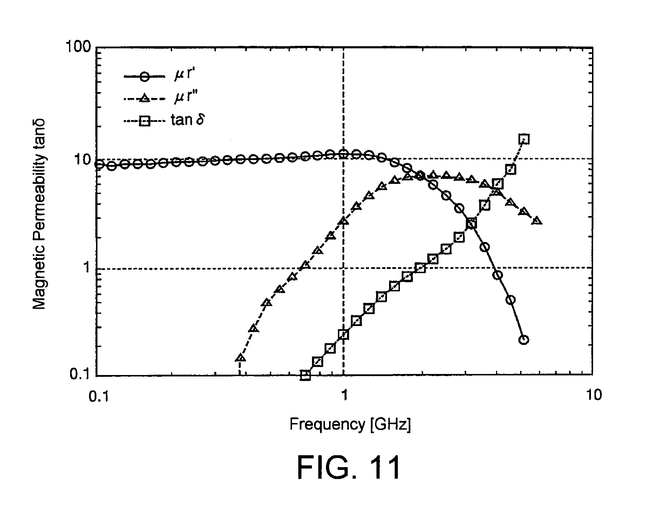

The complex permeability of this composite magnetic material was measured by a parallel line method, and resulted in a relative magnetic permeability μr of 11 and a magnetic loss tan δ of 0.25 at 1.2 GHz (see Fig. 11). Also, the permittivity was measured by a parallel plate method, and resulted in a relative permittivity of 12 and a dielectric loss tan δ of 0.05.

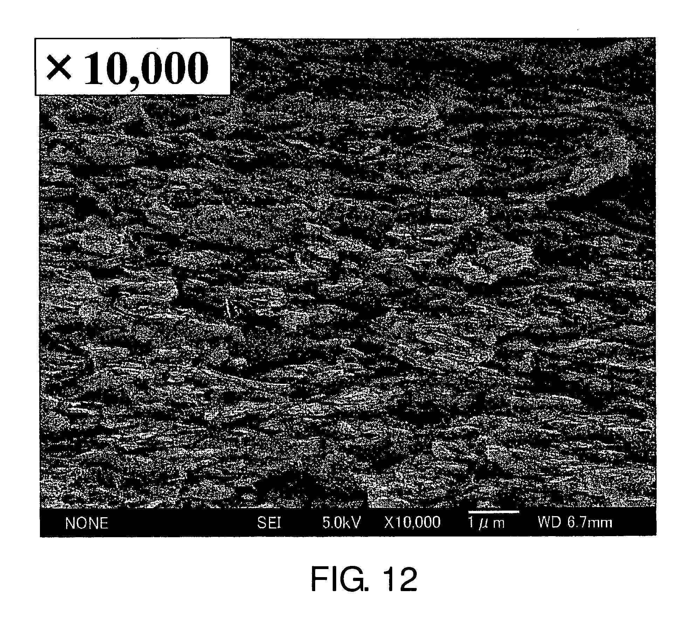

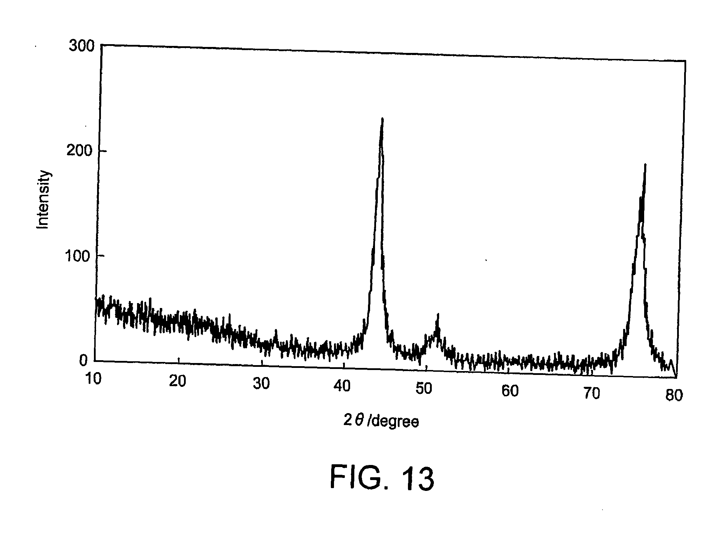

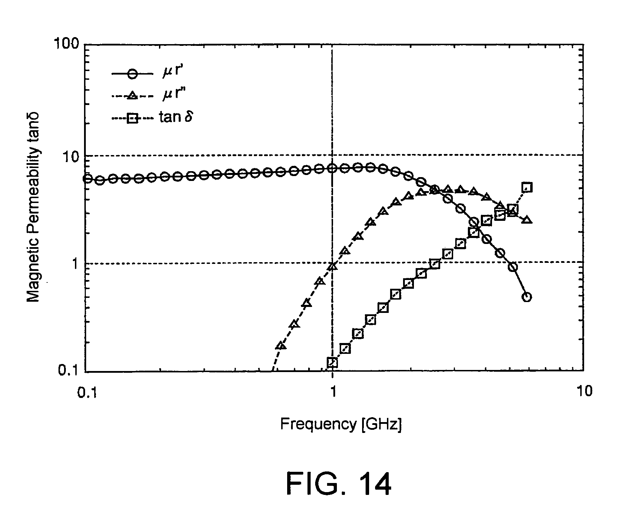

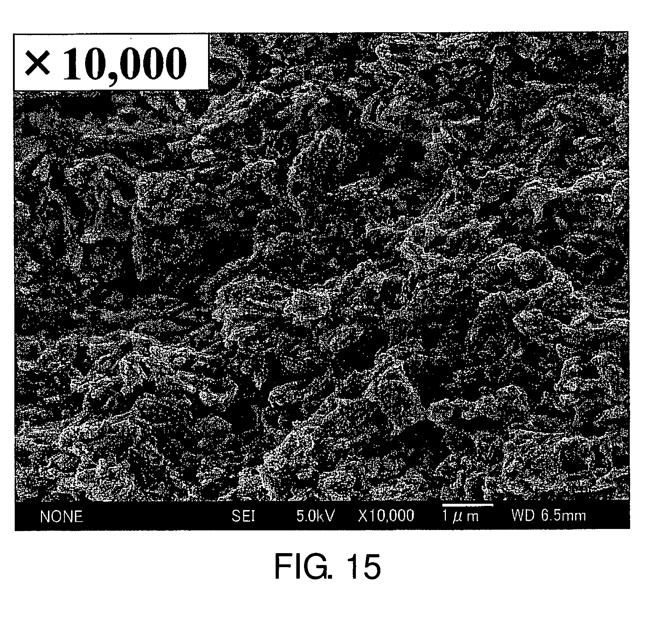

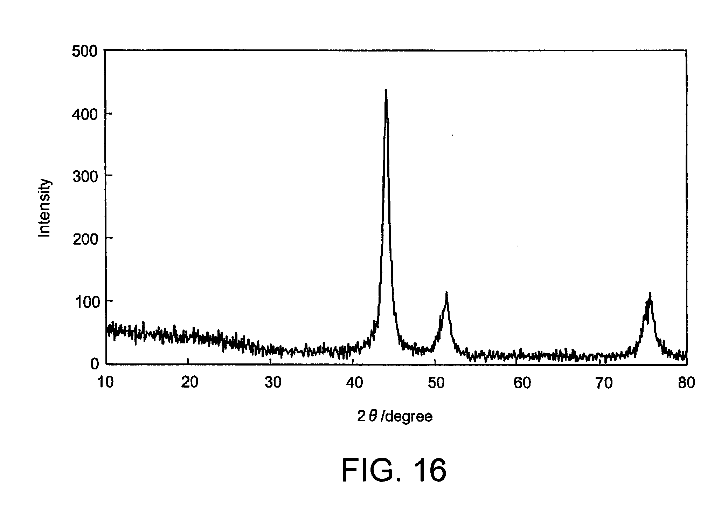

The structure photograph of the composite magnetic body is shown in Fig. 12. It is shown that the magnetic particles are in an elliptic shape and aligned in a specific direction. In this instance, the elliptic particles measured about 0.03 μm in thickness and about 1 μm in length on average, and thus the aspect ratio was about 33. The results of X-ray diffraction shown in Fig. 13 show that specific crystal planes are aligned. For comparison, the magnetic permeability, the sectional photograph and the X-ray diffraction results of a composite magnetic body prepared by a known method without applying a direct-current magnetic field are shown in Figs. 14, 15 and 16, respectively. In this instance, the elliptic particles were not aligned in a specific direction, or orientation was not observed in crystal planes. As a result, it is shown that the relative magnetic permeability was as low as about 7.

EXAMPLE 6

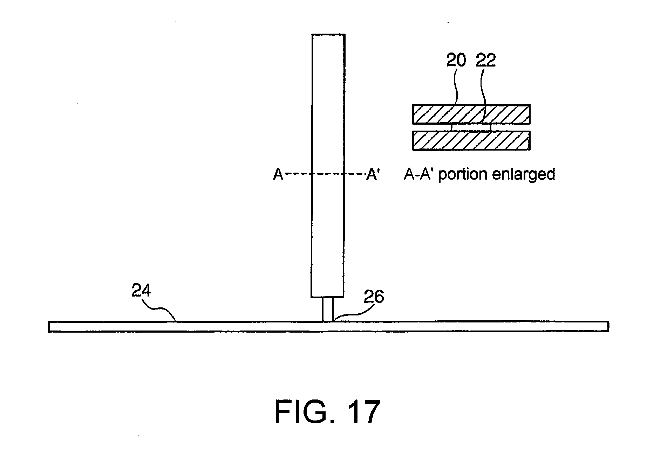

A case will now be described in which the composite magnetic body was used as a monopole antenna, which is an example of electronic components. As shown in Fig. 17, an antenna element had a structure in which a strip conductor 22 having a length of 55 mm and a width of 1.5 mm was sandwiched between two composite magnetic bodies 20 of 50 mm in length, 5 mm in width and 0.5 mm in thickness. The antenna element was connected to the center of a 300 mm square conductor plate 24, and 50 Ω was fed at a connection point as a feeding point 26.

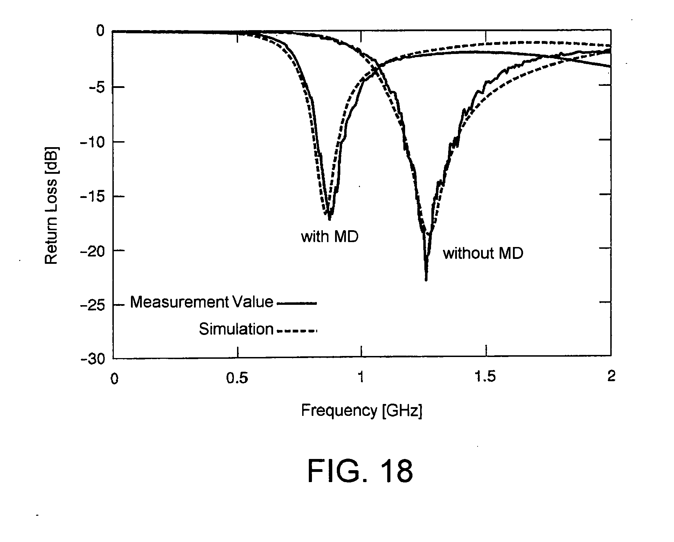

Fig. 18 shows the input reflection characteristics of the antenna. The measurement results favorably coincide with the calculation values obtained by inputting the material constants of the composite magnetic body into an electromagnetic field simulator HFSS. The resonance frequency of the composite magnetic body-loaded antenna (indicated with "With MD" in Fig. 18) was compared with that of a composite magnetic body-unloaded antenna (indicated with "Without MD" in Fig. 18). As a result, the resonance frequency was shifted from 1.26 GHz to 0.88 GHz by loading the composite magnetic body 20. This shows that a greater wavelength compaction was achieved because of the effects of the relative magnetic permeability and relative permittivity of the composite magnetic body, and that the antenna can be about 30% miniaturized.

EXAMPLE 7

One gram of Fe magnetic powder having an average particle size of 0.1 $\mu$m was mixed to a dispersion liquid prepared by dissolving a nitrogen-containing graft polymer as a surfactant in 10 g of 4:1 xylene-cyclopentanone mixed solution. The mixture was subjected to planet stirring for 30 minutes using zirconia beads. The planet stirring was performed at a rotation speed of 2000 rpm and a revolution speed of 800 rpm. To the resulting slurry was added 0.5 g of resin varnish prepared by diluting a polycycloolefin resin to a solid content of 40%, and then the slurry was further mixed by planet stirring for 5 minutes using zirconia beads.

Subsequently, the resulting mixture was placed in a rotary evaporator, and the solvent was evaporated at 50°C under a pressure of 2.7 kPa so that the viscosity was adjusted so as to be suitable for application by a doctor blade method.

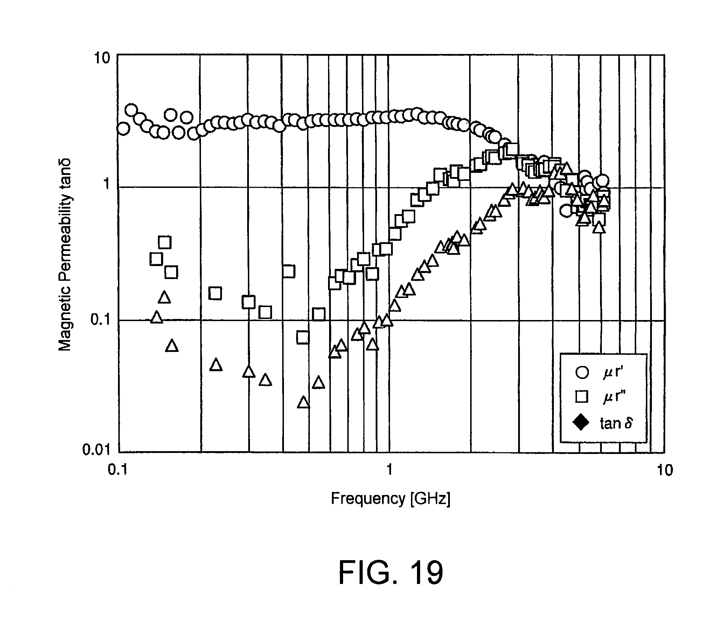

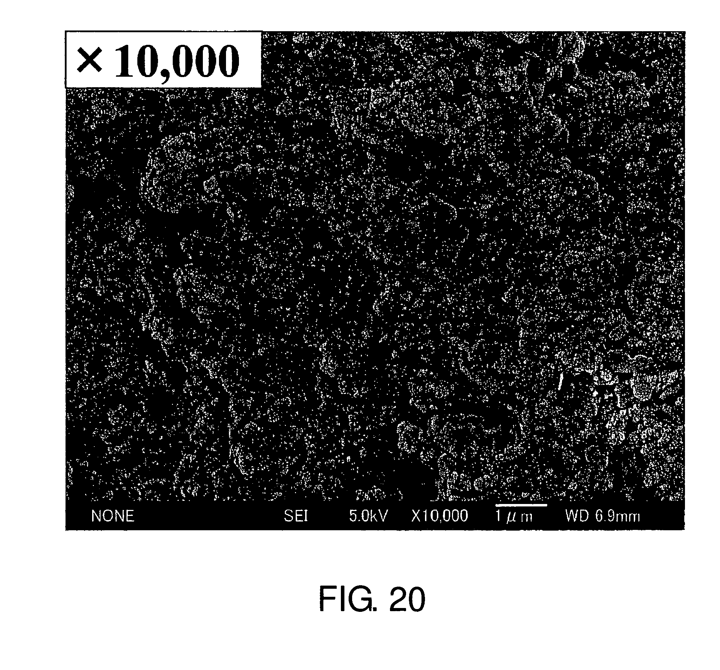

The resulting mixture was formed into a film by a doctor blade method, and the film was dried at room temperature while a magnetic field of $1.6 \times 10^5$ A/m was applied to the film to align the magnetic particles. The resulting dry film was subjected to pressing firing in a vacuum press apparatus. For pressing, the temperature was increased to 130°C over a period of 20 minutes under atmospheric pressure, and subsequently a pressure of 2 MPa was applied and held for 5 minutes. Then, the temperature was increased to 160°C and held for 40 minutes. Thus, the resin was cured to produce a composite magnetic body having an area of 30 mm square and a thickness of about 60 $\mu$m. The complex permeability of the composite magnetic body was measured by a parallel line method, and resulted in a relative magnetic permeability $\mu$r of 5 and a magnetic loss tan $\delta$ of 0.1 at 1 GHz (see Fig. 19). The structure photograph of the composite magnetic body is shown in Fig. 20.

EXAMPLE 8

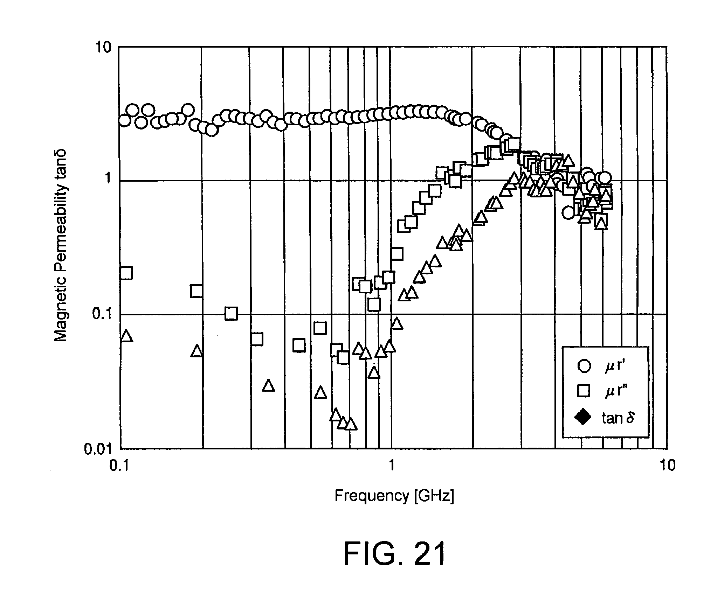

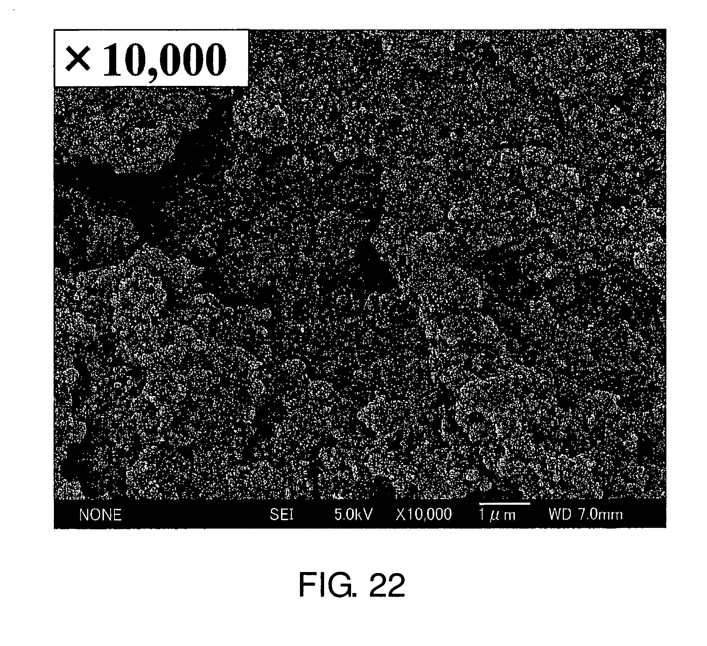

A composite magnetic body having an area of 30 mm square and a thickness of 60 $\mu$m was produced using 1 g of magnetite ($Fe_3O_4$) magnetic powder having an average particle size of 0.1 $\mu$m under the same conditions as in Example 1. The complex permeability of the composite magnetic material was measured by a parallel line method, and resulted in a relative magnetic permeability $\mu$r of 5 and a magnetic loss tan $\delta$ of 0.1 at 1 GHz (see Fig. 21). The structure photograph of the composite magnetic body is shown in Fig. 22.

Industrial Applicability

The present invention can be applied to semiconductor devices, circuit elements, flat display devices, and other high-frequency electronic components, and can also be applied to high-frequency circuit boards including such components to reduce the size and power consumption. Accordingly, the present invention can reduce the size and power consumption of all high-frequency electronic apparatuses including an electronic component and/or a circuit board according to the present invention.

Furthermore, the composite magnetic body according to the present invention can be used for an antenna to miniaturize the antenna.

**Claims**

1. A composite magnetic body comprising a magnetic powder dispersed in an insulating material, the magnetic powder being in a spherical shape or an elliptic shape, wherein the composite magnetic body has any one of the following characteristics (a) to (C):

   (a) the relative magnetic permeability $\mu$r is larger than 1 and the loss tangent tan $\delta$ is 0.1 or less, at a frequency of 1 GHz or 500 MHz;
   (b) the real part $\mu$r' of the complex permeability is more than 10 and the loss tangent tan $\delta$ is 0.3 or less, at a frequency of 1.2 GHz or less; and
   (c) the real part $\mu$r' of the complex permeability is more than 1 at a frequency of 4 GHz or less, and the loss tangent tan $\delta$ is 0.1 or less at a frequency of 1 GHz or less.

2. The composite magnetic body according to claim 1, wherein the real part $\varepsilon$r' of the complex permittivity of the composite magnetic body is 10 or more at a frequency of 1 GHz or less.

3. The composite magnetic body according to claim 1, wherein the real part $\varepsilon$r' of the complex permittivity of the composite magnetic body is 10 or less at a frequency of 1 GHz or less.

4. The composite magnetic body according to claim 1, wherein the insulating material contains 10% to 95% by volume of the magnetic powder.

5. The composite magnetic body according to claim 1, wherein the magnetic powder is easily plastic-deformed in the direction of an axis of easy magnetization by applying a mechanical stress.

6. The composite magnetic body according to claim 1, wherein the magnetic powder has a particle size of 0.01 to 10 $\mu$m.

7. The composite magnetic body according to any one of claims 1 to 6, wherein the magnetic powder is in an elliptic shape having a thickness of 0.01 to 1 $\mu$m, a length of 0.02 to 10 $\mu$m and an aspect ratio (length/thickness) of 2 or more.

8. The composite magnetic body according to claim 7, wherein the elliptic magnetic powder is formed by mechanically deforming the spherical magnetic powder into an elliptic shape in the step of mixing the magnetic powder to a dispersion solvent.

9. The composite magnetic body according to claim 7, wherein the elliptic magnetic powder is aligned in a specific direction in the insulating material.

10. The composite magnetic body according to claim 7, wherein specific planes of the crystals constituting the elliptic magnetic powder are oriented in the specific direction of the elliptic magnetic powder.

11. The composite magnetic body according to claim 7, wherein the longer axis direction of the elliptic magnetic powder coincides with the axis of easy magnetization.

12. The composite magnetic body according to claim 1, wherein the material of the magnetic powder is nickel (Ni) or Permalloy (Fe-Ni alloy), or Permalloy (Fe-Ni alloy) containing at least one metal element selected from the group consisting of aluminum (Al), chromium (Cr), manganese (Mn), cobalt (Co), copper (Cu), zinc (Zn), niobium (Nb), molybdenum (Mo), indium (In), and tin (Sn).

13. The composite magnetic body according to claim 12, wherein the metal element content is 0.1 % to 90% by weight in the magnetic powder.

14. The composite magnetic body according to claim 1, wherein the magnetic powder is an iron-based metal magnetic powder or a metal oxide magnetic powder.

15. The composite magnetic body according to claim 14, wherein the material of the iron-based magnetic powder is at least one selected from the group consisting of iron (Fe), iron (Fe)-silicon (Si)-based alloy, iron (Fe)-nitrogen (N)-based alloy, iron (Fe)-carbon (C)-based alloy, iron (Fe)-boron (B)-based alloy, iron (Fe)-phosphorus (P)-based alloy, iron (Fe)-aluminum (Al)-based alloy, and iron (Fe)-aluminum (Al)-silicon (Si)-based alloy.

16. The composite magnetic body according to claim 15, wherein the material of the iron-based metal magnetic powder contains at least one metal element selected from the group consisting of titanium (Ti), vanadium (V), chromium (Cr), manganese (Mn), cobalt (Co), copper (Cu), zinc (Zn), niobium (Nb), molybdenum (Mo), indium (In), and tin (Sn).

17. The composite magnetic body according to claim 16, wherein the metal element content is 0.1 % to 90% by weight in the magnetic powder.

18. The composite magnetic body according to claim 14, wherein the material of the metal oxide magnetic powder is at least one selected from the group consisting of goethite (FeOOH), hematite ($Fe_2O_3$), magnetite ($Fe_3O_4$), manganese (Mn)-zinc (Zn) ferrite, nickel (Ni)-zinc (Zn) ferrite, cobalt (Co) ferrite, manganese (Mn) ferrite, nickel (Ni) ferrite, copper (Cu) ferrite, zinc (Zn) ferrite, magnesium (Mg) ferrite, lithium (Li) ferrite, manganese (Mn)-magnesium (Mg) ferrite, copper (Cu)-zinc (Zn) ferrite, and manganese (Mn)-zinc (Zn) ferrite.

19. The composite magnetic body according to claim 1, wherein the insulating material is a synthetic resin or liquid phase resin containing at least one selected from the group consisting of polyimide resin, polybenzoxazole resin, polyphenylene resin, polybenzocyclobutene resin, polyarylene ether resin, polysiloxane resin, epoxy resin, polyester resin, fluorocarbon polymer, polyolefin resin, polycycloolefin resin, cyanate resin, polyphenylene ether resin, and polystyrene resin; or at least one ceramic raw material selected from the group consisting of $Al_2O_3$, $SiO_2$, $TiO_2$, $2MgO \cdot SiO_2$, $MgTiO_3$, $CaTiO_3$, $SrTiO_3$, and $BaTiO_3$.

20. A method of manufacturing a composite magnetic body comprising the steps of preparing a slurry by dispersing an insulating material and a spherical or elliptic magnetic powder in a solvent to mix and of applying the slurry, followed by drying and firing, wherein the step of preparing the slurry includes the steps of preparing a dispersion solvent by adding a surfactant in a solvent and of mixing the magnetic powder to the dispersion solvent, and the step of mixing the magnetic powder includes the steps of adding a dispersive medium and of performing rotation/revolution mixing.

21. The method of manufacturing a composite magnetic body according to claim 20, wherein the rotation/revolution mixing is performed at a rotation speed of 100 rpm or more and a revolution speed of 100 rpm or more.

22. The method according to claim 20, wherein the step of preparing the slurry further includes the steps of adding an insulating material to the slurry, followed by mixing, and of removing the dispersive medium from the slurry before or after adding the insulating material.

23. The method according to claim 22, wherein the step of removing the dispersive medium includes the step of dividing the mixture into a portion containing the dispersive medium and a portion not containing the dispersive medium by allowing the mixture to stand, or by centrifugating the mixture.

24. The method according to claim 20, wherein the material of the magnetic powder is nickel (Ni) or Permalloy (Fe-Ni alloy), or Permalloy (Fe-Ni alloy) containing at least one metal element selected from the group consisting of aluminum (Al), chromium (Cr), manganese (Mn), cobalt (co), copper (Cu), zinc (Zn), niobium (Nb), molybdenum (Mo), indium (In), and tin (Sn).

25. The method according to claim 20, wherein the magnetic powder is an iron-based magnetic powder or a metal oxide powder.

26. The method according to claim 25, wherein the material of the iron-based metal magnetic powder is at least one selected from the group consisting of iron (Fe), iron (Fe)-silicon (Si)-based alloy, iron (Fe)-nitrogen (N)-based alloy, iron (Fe)-carbon (C)-based alloy, iron (Fe)-boron (B)-based alloy, iron (Fe)-phosphorus (P)-based alloy, iron (Fe)-aluminum (Al)-based alloy, and iron (Fe)-aluminum (Al)-silicon (Si)-based alloy.

27. The method according to claim 26, wherein the material of the iron-based metal magnetic powder contains at least one metal element selected from the group consisting of titanium (Ti), vanadium (V), chromium (Cr), manganese (Mn), cobalt (Co), copper (Cu), zinc (Zn), niobium (Nb), molybdenum (Mo), indium (In), and tin (Sn).

28. The method according to claim 25, wherein the material of the metal oxide magnetic powder is at least one selected from the group consisting of goethite (FeOOH), hematite ($Fe_2O_3$), magnetite ($Fe_3O_4$), manganese (Mn)-zinc (Zn) ferrite, nickel (Ni)-zinc (Zn) ferrite, cobalt (Co) ferrite, manganese (Mn) ferrite, nickel (Ni) ferrite, copper (Cu) ferrite, zinc (Zn) ferrite, magnesium (Mg) ferrite, lithium (Li) ferrite, manganese (Mn)-magnesium (Mg) ferrite, copper (Cu)-zinc (Zn) ferrite, and manganese (Mn)-zinc (Zn) ferrite.

29. The method according to claim 20, wherein the insulating material is a synthetic resin or liquid phase resin containing at least one selected from the group consisting of polyimide resin, polybenzoxazole resin, polyphenylene resin, polybenzocyclobutene resin, polyarylene ether resin, polysiloxane resin, epoxy resin, polyester resin, fluorocarbon polymer, polyolefin resin, polycycloolefin resin, cyanate resin, polyphenylene ether resin, and polystyrene resin; or at least one ceramic raw material selected from the group consisting of $Al_2O_3$, $SiO_2$, $TiO_2$, $2MgO\cdot SiO_2$, $MgTiO_3$, $CaTiO_3$ $SrTiO_3$, and $BaTiO_3$.

30. The method according to claim 20, wherein the spherical magnetic powder is mechanically deformed into an elliptic shape in the step of mixing the magnetic powder to the dispersion solvent.

31. The method according to claim 20, wherein the dispersive medium added in the step of mixing the magnetic powder is a grain of at least one type selected from the group consisting of metals, metal oxides, sintered oxides, sintered nitrides, sintered silicides, and glass.

32. The method according to claim 31, wherein the dispersive medium contains at least one selected from the group consisting of aluminum, steel, lead, iron oxides, alumina, zirconia, silicon dioxide, titania, silicon nitride, silicon carbide, soda glass, lead glass, and high-specific gravity glass.

33. The method according to claim 31, wherein the dispersive medium has a specific gravity of 6 or more.

34. The method according to claim 33, wherein the dispersive medium contains any one of zirconia, steel, and stainless steel.

35. The method according to claim 20, wherein the dispersive medium is a grain having an average grin size in the range of 0.1 to 3.0 mm.

36. A circuit board comprising the composite magnetic body accoding to any one of claims 1 to 19.

37. An electronic apparatus comprising the circuit board according to claim 36.

38. An electronic component comprising the composite magnetic body accoding to any one of claims 1 to 19.

39. An electronic apparatus comprising the electronic component according to claim 38.

40. A circuit board comprising a composite magnetic body manufactured by the method according to any one of claims 20 to 35.

**41.** An electronic apparatus comprising the circuit board according to claim 40.

**42.** An electronic component comprising a composite magnetic body manufactured by the method according to any one of claims 20 to 35.

**43.** An electronic apparatus comprising the electronic component accoding to claim 42.

FIG. 1

FIG. 2

FIG. 3

× 10,000

NONE          SEI      5.0kV    X10,000    1 μm      WD 6.7mm

FIG. 4

FIG. 5

FIG. 6

FIG. 7

FIG. 8

EP 2 117 018 A1

FIG. 9

FIG. 10

FIG. 11

FIG. 12

FIG. 13

FIG. 14

×10,000

NONE    SEI    5.0kV    X10,000    1 μm    WD 6.5mm

FIG. 15

EP 2 117 018 A1

FIG. 16

20 22

A -------|-------A'    A-A' portion enlarged

24

26

FIG. 17

FIG. 18

FIG. 19

FIG. 20

FIG. 21

FIG. 22

## INTERNATIONAL SEARCH REPORT

| International application No. |
| --- |
| PCT/JP2008/050821 |

**A. CLASSIFICATION OF SUBJECT MATTER**
*H01F1/26*(2006.01)i, *H01F1/147*(2006.01)i, *H01F1/24*(2006.01)i, *H01F1/37* (2006.01)i, *H01F41/02*(2006.01)i, *H05K1/02*(2006.01)i, *H05K1/03*(2006.01)i, *H05K9/00*(2006.01)i
According to International Patent Classification (IPC) or to both national classification and IPC

**B. FIELDS SEARCHED**

Minimum documentation searched (classification system followed by classification symbols)
H01F1/26, H01F1/147, H01F1/24, H01F1/37, H01F41/02, H05K1/02, H05K1/03, H05K9/00

Documentation searched other than minimum documentation to the extent that such documents are included in the fields searched
| Jitsuyo Shinan Koho | 1922-1996 | Jitsuyo Shinan Toroku Koho | 1996-2008 |
| Kokai Jitsuyo Shinan Koho | 1971-2008 | Toroku Jitsuyo Shinan Koho | 1994-2008 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| X | JP 2006-269134 A  (Tohoku University), | 1-8,12-14 |
|   | 05 October, 2006 (05.10.06), | 19-25,29-43 |
| Y | Par. Nos. [0040] to [0063], [0074] to [0078] | 9-11,15-18 |
|   | & WO 2006/101031 A1 | 26-28 |
| Y | JP 2004-247663 A  (NEC Tokin Corp.), | 9-11 |
|   | 02 September, 2004 (02.09.04), |   |
|   | Par. No. [0030] |   |
|   | (Family: none) |   |
| Y | JP 2006-307209 A  (Nitta Corp.), | 9-11,15-18 |
|   | 09 November, 2006 (09.11.06), | 26-28 |
|   | Par. Nos. [0047], [0053] |   |
|   | (Family: none) |   |

☒ Further documents are listed in the continuation of Box C.  ☐ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered    to be of particular relevance |  |  |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means |  |  |
| "P" | document published prior to the international filing date but later than the priority date claimed | "&" | document member of the same patent family |

| Date of the actual completion of the international search | Date of mailing of the international search report |
| --- | --- |
| 16 April, 2008 (16.04.08) | 01 May, 2008 (01.05.08) |

| Name and mailing address of the ISA/ | Authorized officer |
| --- | --- |
| Japanese Patent Office |  |
| Facsimile No. | Telephone No. |

Form PCT/ISA/210 (second sheet) (April 2007)

**INTERNATIONAL SEARCH REPORT**

International application No.

PCT/JP2008/050821

C (Continuation).   DOCUMENTS CONSIDERED TO BE RELEVANT

| Category* | Citation of document, with indication, where appropriate, of the relevant passages | Relevant to claim No. |
|---|---|---|
| Y | JP 2005-286306 A  (Sony Corp.),<br>13 October, 2005 (13.10.05),<br>Par. Nos. [0013] to [0022]<br>(Family: none) | 15-18,26-28 |
| Y | JP 9-153405 A  (Alps Electric Co., Ltd.),<br>10 June, 1997 (10.06.97),<br>Par. No. [0007]<br>& US 5755986 A1           & DE 19639428 A1 | 15-18,26-28 |
| A | JP 2004-087627 A  (Tadahiro OMI),<br>18 March, 2004 (18.03.04),<br>Par. Nos. [0043] to [0045]<br>& US 2006/0158865 A1     & WO 2004/019664 A1 | 1-43 |

Form PCT/ISA/210 (continuation of second sheet) (April 2007)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2007012092 A
- JP H11354973 A
- JP 2006269134 A